# EUROPEAN PATENT SPECIFICATION

(11) **EP 0 361 589 B1**
(45) Date of publication and mention of the grant of the patent: **19.12.2001**
(21) Application number: 89202351.6
(22) Date of filing: 18.09.1989
(51) Int. Cl.: H01L 29/08, H01L 29/72, H01L 29/41

(54) **Segmented-anode lateral insulated-gate bipolar transistor devices**
Laterale bipolare Transistoranordnungen mit isolierter Steuerelektrode mit geteilter Anode
Transistors bipolaires latéraux à grille isolée comportant une anode fractionnée

(30) Priority: 22.09.1988 US 249028; 12.04.1989 US 336982
(43) Date of publication of application: 04.04.1990
(73) Proprietor: Koninklijke Philips Electronics N.V., 5621 BA Eindhoven (NL)
(72) Inventor: Mukherjee, Satyetdranath, NL-5656 AA Eindhoven (NL); Tsui, Paul Gin-Yea, NL-5656 AA Eindhoven (NL)
(74) Representative: Duijvestijn, Adrianus Johannes

(56) References cited:
- EP-A- 0 272 753
- EP-A- 0 280 535
- - -
- GB-A- 2 197 987
- INTERNATIONAL ELECTRON DEVICES MEETING, TECHNICAL DIGEST, Washington, D.C., 6th-9th December 1987, pages 778-781, IEEE, New York, US; S. MUKHERJEE et al.: "LDMOS and LIGT's in CMOS technology for power integrated circuits"
- ELECTRONICS LETTERS, vol. 22, no. 19, September 1986, pages 1003-1005, Stevenage, Herts, GB; J.K.O. SIN et al.: "Hybrid Schottky injection MOS-gated power transistor
- IEEE TRANSACTIONS ON ELECTRON DEVICES, vol. ED-33, no. 12, December 1986, pages 1956-1963, IEEE, New York, US; D.N. PATTANAYAK et al.: "n-Channel lateral insulated gate transistors: part I - steady-state characteristics"

## Description

### Background of the invention

This invention relates to high-voltage integrated-circuit (IC) devices and, more particularly to IC devices of the type commonly referred to as lateral insulated-gate bipolar transistor (LIGT or LIGBT) devices.

High-voltage IC devices are utilized in a number of applications of commercial importance. Various lateral metal-oxide-semiconductor (MOS) structures have been proposed for realizing such devices. Designers of these lateral MOS structures have focused particular attention on trying to achieve low on-resistance and short turn-off-time characteristics in a small-area IC chip.

One known structure of this general type is a lateral double-diffused MOS transistor (LDMOS or LDMOST) that exhibits an excellent turn-off-time property. But, to achieve the relatively low values of on-resistance that are required in some high-power applications, the area of a typical LDMOS device must sometimes be made uneconomically large.

LIGT devices are similar in structure to LDMOS devices. (See, for example, "LDMOS and LIGTs in CMOS Technology for Power Integrated circuits" by S. Mukherjee et al, Proceedings of the IEDM-International Electron Devices Meeting, Washington, D.C., December 6-9, 1987, pages 778-781; and "Comparison of High Voltage Devices for Power Integrated Circuits" by R. Jayaraman et al, IEDM Technical Digest, 1984, pages 258-261.) LIGT devices can provide a specified low value of on-resistance in an area that is considerably smaller than that required by an LDMOS. But LIGT devices as heretofore proposed are typically characterized by a turn-off time that is disadvantageously long relative to that of an LDMOS. Representative prior-art devices are shown in U.S. patents Nos. 4,618,872 and 4,672,407; European Patent Applications Nos. 0 111 803, 0 201 945, 0 228 107; and U.K. Patent Application 2 088 631.

Accordingly, efforts have been directed by workers skilled in the art aimed at trying to decrease the turn-off time of an LIGT device while substantially preserving its desirable low-on-resistance and small-area properties. It was recognized that these efforts, if successful, could provide improved LIGT devices that would be attractive for use in a wide variety of high-power applications of commercial significance.

### Summary of the Invention

In accordance with the principles of the present invention, an LIGT device includes a highly doped segmented diffusion region of one conductivity type formed in a semiconductor layer of the opposite conductivity type. A drain contact overlies the segmented region. When the device is turned on, the individual segments inject minority carriers into a drift region of the layer. Bipolar carrier operation and conductivity modulation attributable to these injected carriers cause the specific on-resistance of the device to be attractively low.

In one embodiment of the invention, the regions in the layer between the aforementioned segments comprise highly doped diffusion regions of the opposite conductivity type. These last-mentioned regions facilitate the collection of majority carriers from the drift region of the device and thereby speed up the turn-off process.

In another embodiment of the present invention, the carrier-collection process in the device at turn-off is further enhanced. This is done by positioning a continuous highly doped diffusion region of the opposite conductivity type in the layer adjacent to the entire extent of the segmented region.

In still another embodiment of the invention, the regions between the aforementioned segments comprise exposed portions of the underlying layer in which the segments were formed. When a suitable conductive drain material is deposited over the segments and the exposed portions therebetween, schottky-barrier contacts are formed between the material and the exposed underlying layer. These contacts speed up turn-off of the device both by limiting the number of carriers injected by the segments at turn-on and by enhancing the carrier-collection process at turn-off. In yet another embodiment, turn-off of the device is further speeded up by positioning a continuous highly doped diffusion region of the opposite conductivity type in the layer adjacent to the entire extent of the segmented region that includes the aforementioned Schottky-barrier contacts.

### Brief Description of the Drawing

A complete understanding of the present invention and of the above and other features and advantages thereof may be gained from a consideration of the following detailed description presented herein-below in conneciton with the accompanying drawing, not drawn to scale, in which:
Figure 1 is a cross-sectional side view of a conventional LIGT device;
Figure 2 is a top view of the right-hand or drain portion of the Figure 1 device;
Figures 3 through 6 each show a top view of the right-hand portion of the Figure 1 device as modified in accordance with the principles of the present invention to form four respective LIGT embodiments thereof;
and Figure 7 is a graphical depiction of turn-off time versus specific on-resistance both for a conventional LIGT device and for a specific illustrative LIGT device made in accordance with the principles of the present invention.

### Detailed Description

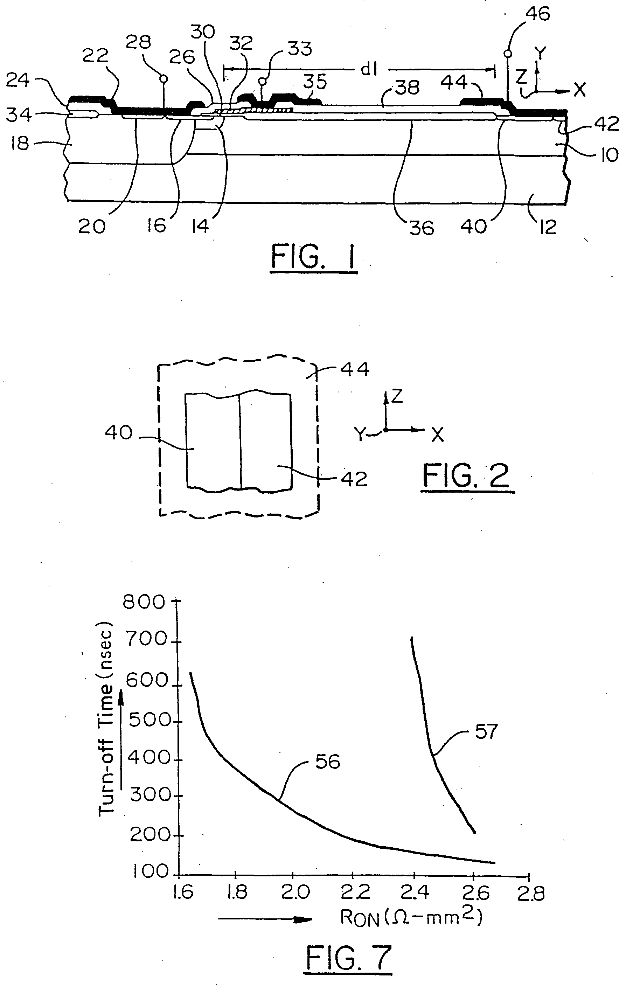

Figure 1 represents in simplified schematic form a conventional LIGT device of the type shown in Figure 2 of the aforecited article by Mukherjee et al. A description of the structure and operation of this priorly known device is necessary as a basis for understanding the present invention.

The Figure 1 device includes an n-type epitaxial layer 10 grown on a p-type substrate 12. A self-aligned double-diffused channel of the depicted device comprises p-type region 14 and n⁺-type region 16. Advantageously, a deep isolation p⁺-type diffusion 18 shorts the channel to the substrate 12. A p⁺-type contact region 20 is formed adjacent to the region 16.

Conductive portion 22 shown in Figure 1 constitutes the source contact of the device. The portion 22, which overlies deposited oxide regions 24 and 26, establishes electrical contact to the regions 16 and 20. Illustratively, terminal 28 connected to the source contact 22 is maintained at a point of reference potential such as ground.

The Figure 1 device also includes gate oxide portion 30 and an overlying conductive portion 32 that comprises the gate electrode of the illustrated structure. Terminal 33 is connected to the gate electrode 32 by conductive portion 35. Also shown in Figure 1 are grown oxide regions 34 and 36 and another deposited oxide region 38.

The right-hand part of the conventional LIGT structure represented in Figure 1 comprises the drain portion of the device. In particular, the drain is defined by a continuous elongated Z-direction p⁺-type diffusion region 40 that is adjacent to a co-extensive n⁺-type diffusion region 42. (The same structure with the p⁺-type region 40 replaced by n⁺-type region 42 comprises a conventional LDMOS device.)

Conductive portion 44 in Figure 1 constitutes the drain contact of the device. The portion 44 establishes electrical contact to the regions 40 and 42. In turn, terminal 46 is connected to the drain contact 44.

The side-by-side arrangement of the regions 40 and 42 of the conventional device of Figure 1 is illustrated in the top view of Figure 2. Figure 2 also indicates in dash lines the overlying conductive drain contact 44.

As is well known, a conventional LIGT device of the type represented in Figure 1 includes a so-called drift region. The width d1 of the drift region is indicated in Figure 1.

By way of example, the drain terminal 46 of Figure 1 is designed to be connected to a relatively high positive direct-current voltage such as +500 volts. To operate the depicted device as a high-voltage switch, control voltages are applied to the gate terminal 33. If the terminal 33 is maintained at ground potential, no current flows in the structure between the source terminal 28 and the drain terminal 46. The switch is thus off. On the other hand, if a positive voltage, for example a positive voltage in the range of about 10-to-20 volts, is applied to the gate terminal 33, a portion of the layer 14 underlying the gate is controlled to cause current to flow in the structure between the source and drain terminals. In that way, the switch is turned on.

When the conventional Figure 1 device is on, electrons from the drift region are collected by the regions 40 and 42. In turn, the p⁺-type region 40 injects minority carriers (holes) into the n-type layer 10. These carriers enhance the source-to-drain current flow of the device by a process of conductivity modulation in the drift region. Additionally, the electrons constitute base current for a pnp-type bipolar transistor formed by the p⁺-type region 40, the n-type layer 10 and the p-type substrate 12. Hole current flows through this bipolar transistor via the substrate 12 and the p⁺-type region 18 to the source terminal 28. This constitutes in effect a low resistance in parallel with the source-to-drain electron current flow through the drift region.

Due to the aforementioned minority carrier injection process, a known device of the type shown in Figure 1 exhibits a considerably reduced specific on-resistance property relative to an LDMOS device. In turn, this has increased the power handling capability of such devices and has enabled a reduction in IC chip size for many high-voltage applications.

When the Figure 1 device is to be turned off, a suitable control voltage (for example ground) is applied to the gate terminal 33. In effect, this turns off the channel of the structure and thus no additional electrons are introduced into the drift region to flow toward the drain. However, at the instant of turn-off, a number of electrons and holes exist in the drift region. These holes move to the source terminal 28 via the drift region and also via the previously described bipolar-transistor path. At the instant of turn-off, the electrons that exist in the drift region are collected to some extent by the n⁺-type region 42 but, for high injection levels, primarily by the p⁺-type region 40. This is so due to the physical proximity of the high-positive-potential region 40 to on-coming electrons. As these electrons are collected by the region 40, additional holes are injected by the region 40 into the n-type layer 10. In turn, these holes then flow to the source via the two previously mentioned parallel paths. As a result, the conduction process in the device is prolonged beyond the instant of turn-off. Eventually, all the electrons will have been collected and conduction terminates. But, in practice, the turn-off time attributable to the described phenomenon can be undesirably long (for example, about 200-to-400 nanoseconds) for some applications.

In accordance with the principles of the present invention, the collection of electrons from the drift region of an LIGT device is speeded up at turn-off while maintaining a relatively low specific on-resistance characteristic for the device.

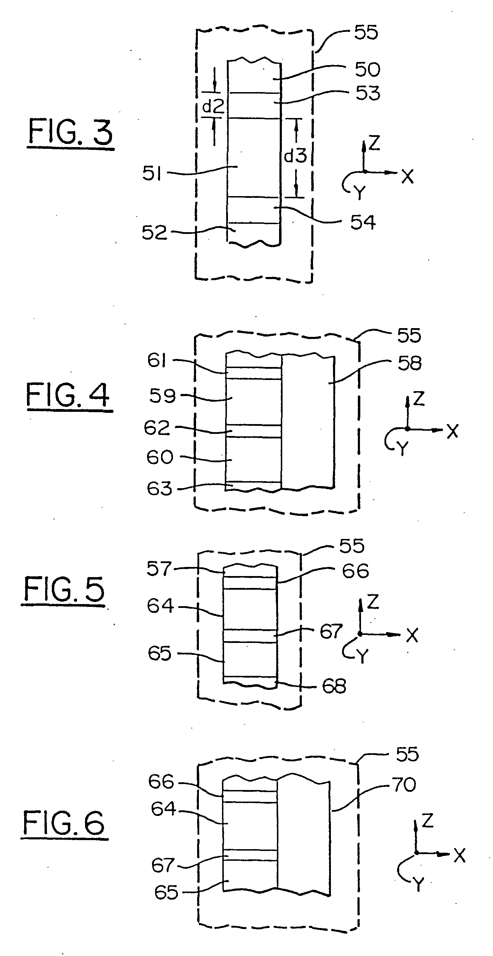

Illustratively, an LIGT device made in accordance with this invention is identical with the conventional device depicted in Figures 1 and 2 except for unique modifications in the drain region thereof. Accordingly, in the description below and in the drawing, only the modified portion of the priorly known device described above will be explicitly specified. For each embodiment of the present invention, a top view of the drain region is shown and will be described in detail. Each such drain region corresponds to and is a direct substitute for the conventional drain region represented in the top view of Figure 2. In each case, the particular manner in which the modified drain region made in accordance with this invention replaces the right-hand portion of the Figure 1 structure (which is shown also in Figure 2) will be apparent. Thus, the top views of Figures 3 through 6, when considered together with Figure 1, constitute in effect clear and complete representations of four different embodiments of the present invention.

In the embodiment represented in Figure 3, the n⁺-type region 42 of Figure 1 is omitted altogether. Additionally, the continuous elongated p⁺-type region 40 of Figure 1 is replaced with a segmented longitudinally extending Z-direction region that includes multiple p⁺-type diffusion segments formed in an n-type layer (such as the layer 10 of Figure 1). Three of these segments 50 through 52 are shown in Figure 3. Further, in accordance with this embodiment of the invention, an n⁺-type diffusion region is formed in the n-type layer between each spaced-apart pair of the p⁺-type segments. Two of these n⁺-type regions 53 and 54 are shown in Figure 3. Additionally, the outline of the conductive drain contact that overlies and makes electrical contact to the diffusions 50 through 54 is represented in Figure 3 by dash line 55.

Subsequent to the initiation of turn-off in the LIGT device represented by Figure 3, the depicted n⁺-type regions 53 and 54 collect some of the remaining electrons coming from the drift region that otherwise would flow to the continuous p⁺-type region included in a conventional LIGT device. Thus, a smaller number of electrons are collected by the p⁺-type segments 50 through 53 than is the case in a known device of the type shown in Figure 1. Hence, fewer holes are correspondingly injected into the n-type layer 10 subsequent to turn-off. Consequently, the conduction process in the device terminates relatively quickly. As a result, the Figure 3 device exhibits an extremely fast turn-off-time property.

The presence of the n⁺-type regions 53 and 54 (Figure 3) causes fewer holes to be injected into the drift region during conduction than if a continuous p⁺-type region such as the region 40 (Figure 1) were included in the device. This effect contributes to speeding up the turn-off process by limiting the number of holes that must be cleared from the device at turn-off. At the same time, however, limiting hole injection also tends to decrease the aforementioned enhancement attributable to conductivity modulation and bipolar operation. But, in practice, this enhancement effect is a non-linear one, so that limiting hole injection does not correspondingly increase the on-resistance of the device.

Significantly, the Figure 3 structure also requires less total IC chip area than does the Figure 1 design. This is so because the X-direction width of the region 40 (Figure 2) and the X-direction width of the segmented region shown in Figure 3 are approximately the same, but the Figure 3 device does not include an adjacent n⁺-type region such as the region 42 indicated in Figure 2.

By changing the ratio of the Z-direction width d2 of the n⁺-type regions 53 and 54 to the Z-direction width d3 of the p⁺-type regions 50 through 52, the operating properties of the Figure 3 device can be selectively controlled during fabrication of the structure. As the width ratio is increased, the electron-collection process at turn-off is enhanced. Turn-off time is therefore decreased. But this decrease is accompanied by a decrease in the number of holes injected during conduction, which, as indicated above, results in some increase in the specific on-resistance of the device.

Conversely, as the aforementioned width ratio is decreased, the electron-collection process at turn-off becomes less efficient and the turn-off time of the device increases. But this increase in turn-off time is accompanied by an increase in the number of holes injected into the drift region during conduction which, in turn, decreases the specific on-resistance characteristic of the device.

Thus, it is apparent that a device made in accordance with the principles of the present invention possesses a significant design flexibility. This flexibility enables the parameters of the device to be easily tailored for particular applications to exhibit specified turn-off time and/or specific on-resistance properties.

The aforementioned design flexibility is illustrated graphically in Figure 7. Curve 56 represents the turn-off time versus specific on-resistance characteristic of an LIGT device of the type shown in Figure 3, which includes an interleaved segmented diffusion comprising highly doped regions 50 through 54 having respectively alternating conductivities. By contrast, curve 57 represents the characteristic of a conventional LIGT device such as the one depicted in Figures 1 and 2, which includes continuous drain diffusions.

The device represented in Figure 4 is similar to the Figure 3 one but includes an additional n⁺-type region 58 adjacent to a segmented region that comprises p⁺-type segments 59 and 60 interleaved with n⁺-type segments 61 through 63. The addition of the region 58 to a Figure 3-type device further enhances the electron-collection process at turn-off. But this additional enhancement is, of course, achieved at the expense of increased IC chip area.

Figure 5 illustrates another area-efficient embodiment of the present invention. As in Figures 3 and 4, the Figure 5 device includes a longitudinally extending Z-direction region that includes multiple p⁺-type diffusion segments. Three of these segments 57, 64 and 65 are shown in Figure 5. The spaces between adjacent ones of these segments constitute portions 66 through 68 of the top surface of the underlying n-type layer (such as the layer 10 shown in Figure 1) which is doped, for example, to an impurity concentration such that when a suitable material such as aluminium (or platinum, titanium or cobalt) is deposited to form a drain contact over the segmented region, Schottky-barrier contacts are formed. In particular, Schottky-barrier contacts are formed between the deposited material (represented by dash line 55) and the underlying n-type layer in the indicated spaces 66 through 68.

The aforementioned Schottky-barrier contacts included in the Figure 5 embodiment collect electrons during turn-off of the indicated device and thus speed up the turn-off process. Additionally, the Schottky-barrier contacts clamp adjacent portions of the p⁺-type segments 57, 64 and 65, thereby limiting hole injection during conduction of the device.

At the expense of increasing the IC chip area of the Figure 5 device, the electron-collection process at turn-off can be still further enhanced by adding an n⁺-type continuous diffusion adjacent to the segmented region of Figure 5. Such a diffusion region, designated by reference numeral 70, is shown in the embodiment represented in Figure 6 which otherwise may be identical to the Figure 5 device.

Each of the devices represented in Figures 4 through 6 is also characterized by the design flexibility discussed above in connection with the Figure 3 device. In each device, the turn-off time and specific on-resistance properties can be selectively controlled approximately in the manner represented in Figure 7 by varying the aforespecified segment-width ratio.

Finally, it is to be understood that the above-described arrangements are only illustrative of the principles of the present invention. In accordance with these principles, numerous modifications and alternatives may be devised by those skilled in the art without departing from the spirit and scope of the invention. For example, although emphasis herein has been placed on specific illustrative LIGT devices having particular conductivity regions therein, it is apparent that all the aforespecified conductivity types may if desired be respectively reversed.

## Claims

1. A lateral insulated gate bipolar transistor, comprising
a semiconductor substrate of one conductivity type,
a layer of the opposite conductivity type formed on the surface of said substrate,
a laterally extending drift region defined in said layer,
means including a source and gate for controlling the introduction of majority carriers into one end of said, drift region, and a drain region comprising a zone of said one conductivity type and a highly doped zone of said opposite conductivity type both having a depth less than the thickness of the layer of the opposite conductivity type, **characterized in that** said zones comprises interleaved first and second segments adjacent the other end of said drift region, said first segments being of the one conductivity type and being adapted both to collect majority carriers from and to inject minority carriers into said drift region, and said second segments being of the opposite conductivity type and being adapted only to collect majority carriers from said drift region, said first and said second segments, at the side directed to the source, and at the intersection with the surface, both abutting on the drift region.

2. A device as in claim 1, **characterized in that** said drain region further includes highly doped portions of said other conductivity type in said layer between said segments.

3. A device as in claim 2, **characterized in that** said drain region further includes a conductive drain contact overlying said segments and portions and in electrical contact therewith.

4. A device as in claim 2, **characterized in that** said drain region still further includes a highly doped region of said other conductivity type in said layer adjacent to co-extensive with said segments and portions.

5. A device as in claim 4, **characterized in that** said drain region further includes an overlying conductivity drain contact in electrical contact with said segments and portions and with said highly doped region of said other conductivity type.

6. A device as in claim 1, **characterized in that** said drain region further includes a conductive drain contact overlying said segments and said layer in the spaces between said segments to form Schottky-barrier contacts between said drain contact and said underlying layer in the spaces between said segments.

7. A device as in claim 6, **characterized in that** said drain region still further includes a highly doped region of said other conductivity type in said layer underlying said drain contact adjacent to and co-extensive with said segments and Schottky-barrier contacts.

## Patentansprüche

1. Lateraler Bipolartransistor mit isoliertem Gate, welcher aufweist:
ein Halbleitersubstrat des ersten Leitfähigkeitstyps;
eine Schicht des entgegengesetzten Leitfähigkeitstyps, welche auf der Oberseite des Substrats ausgebildet ist;
eine sich lateral erstreckende Driftzone, welcher in dieser Schicht definiert ist;
Mittel mit einer Source und einem Gate, um das Einbringen von Majoritätsträgern in ein Ende der Driftzone zu steuern, sowie einem Drainbereich, welcher eine Zone des ersten Leitfähigkeitstyps und eine stark dotierte Zone des entgegengesetzten Leitfähigkeitstyps aufweist, wobei beide eine Tiefe vorsehen, welche geringer als die Dicke der Schicht des entgegengesetzten Leitfähigkeitstyps ist, **dadurch gekennzeichnet, dass** die Zonen erste und zweite Segmente aufweisen, welche in Angrenzung an das andere Ende der Driftzone ineinander greifen, wobei die ersten Segmente vom ersten Leitfähigkeitstyp sind und sowohl Majoritätsträger von der Driftzone aufnehmen als auch Minoritätsträger in diese injizieren können, und wobei die zweiten Segmente vom entgegengesetzten Leitfähigkeitstyp sind und lediglich Majoritätsträger von der Driftzone aufnehmen können, wobei die ersten und zweiten Segmente auf der zu der Source gerichteten Seite und an dem Schnittpunkt mit der Oberfläche beide an die Driftzone angrenzen.

2. Anordnung nach Anspruch 1, **dadurch gekennzeichnet, dass** der Drainbereich in der Schicht zwischen den Segmenten weiterhin stark dotierte Teile des anderen Leitfähigkeitstyps aufweist.

3. Anordnung nach Anspruch 2, **dadurch gekennzeichnet, dass** der Drainbereich außerdem einen leitenden Drainkontakt aufweist, welcher über den Segmenten und Teilen vorgesehen ist und sich in elektrischem Kontakt mit diesen befindet.

4. Anordnung nach Anspruch 2, **dadurch gekennzeichnet, dass** der Drainbereich darüber hinaus eine stark dotierte Zone des anderen Leitfähigkeitstyps in der angrenzenden, mit den Segmenten und Teilen flächengleichen Schicht aufweist.

5. Anordnung nach Anspruch 4, **dadurch gekennzeichnet, dass** der Drainbereich außerdem einen darüber liegenden Leitfähigkeitsdrainkontakt in elektrischem Kontakt mit den Segmenten und Teilen und mit der stark dotierten Zone des anderen Leitfähigkeitstyps aufweist.

6. Anordnung nach Anspruch 1, **dadurch gekennzeichnet, dass** der Drainbereich weiterhin einen leitenden Drainkontakt aufweist, welcher über den Segmenten und der Schicht in den Zwischenräumen zwischen den Segmenten vorgesehen ist, um Schottky-Kontakte zwischen dem Drainkontakt und der darunter liegenden Schicht in den Zwischenräumen zwischen den Segmenten zu bilden.

7. Anordnung nach Anspruch 6, **dadurch gekennzeichnet, dass** der Drainbereich überdies in der unter dem Drainkontakt liegenden Schicht in Angrenzung an die Segmente und Schottky-Kontakte und flächengleich mit diesen eine stark dotierte Zone des anderen Leitfähigkeitstyps aufweist.

## Revendications

1. Transistor bipolaire latéral à grille isolée comportant
un substrat semi-conducteur d'un type de conductivité,
une couche du type de conductivité opposé qui est formée sur la surface dudit substrat,
une région de migration s'étendant latéralement qui est définie dans ladite couche,
des moyens incorporant une source et une grille pour commander l'introduction de porteurs majoritaires dans une extrémité de ladite région de migration, et une région de drain comprenant une zone dudit un type de conductivité et une zone fortement dopée dudit type de conductivité opposé, les deux ayant une profondeur qui est inférieure à l'épaisseur de la couche du type de conductivité opposé, **caractérisé en ce que** lesdites zones comprennent des premiers et des deuxièmes segments qui sont contigus à l'autre extrémité de ladite région de migration, lesdits premiers segments étant d'un type de conductivité et étant adaptés tous les deux de manière à réunir des porteurs majoritaires en provenance de et de manière à injecter des porteurs minoritaires dans ladite région de migration, et lesdits deuxièmes segments étant du type de conductivité opposé et étant adaptés de manière à réunir seulement des porteurs majoritaires en provenance de ladite région de migration, lesdits premiers et lesdits deuxièmes segments, du côté étant dirigé vers la source, et à l'intersection avec la surface, s'appuyant tous les deux sur la région de migration.

2. Dispositif selon la revendication 1, **caractérisé en ce que** ladite région de drain renferme encore des parties fortement dopées dudit autre type de conductivité dans ladite couche entre lesdits segments.

3. Dispositif selon la revendication 2, **caractérisé en ce que** ladite région de drain renferme encore un contact de drain conducteur qui se situe par-dessus lesdits segments et lesdites parties et qui y établit un contact électrique.

4. Dispositif selon la revendication 2, **caractérisé en ce que** ladite région de drain renferme encore une région fortement dopée dudit autre type de conductivité dans ladite couche qui est contiguë à et co-extensive avec lesdits segments et lesdites parties.

5. Dispositif selon la revendication 4, **caractérisé en ce que** ladite région de drain renferme encore un contact de drain de conductivité sus-jacent qui établit un contact électrique avec lesdits segments et lesdites parties et avec ladite région fortement dopée dudit autre type de conductivité.

6. Dispositif selon la revendication 1, **caractérisé en ce que** ladite région de drain renferme encore un contact de drain conducteur qui se situe par-dessus lesdits segments et ladite couche dans les espaces présents entre lesdits segments pour constituer des contacts de barrière de Schottky entre ledit contact de drain et ladite couche sous-jacente dans les espaces présents entre lesdits segments.

7. Dipositif selon la revendication 6, **caractérisé en ce que** ladite région de drain renferme encore une région fortement dopée dudit autre type de conductivité dans ladite couche qui se situe par-dessous ledit contact de drain qui est contigu à et co-extensif avec lesdits segments et lesdits contacts de barrière de Schottky.
